Europäisches Patentamt

European Patent Office

Office européen des brevets

(19)

(11) Numéro de publication : **0 038 239**
**B1**

(12) **FASCICULE DE BREVET EUROPÉEN**

(45) Date de publication du fascicule du brevet :
**13.06.84**

(21) Numéro de dépôt : **81400495.8**

(22) Date de dépôt : **27.03.81**

(51) Int. Cl.³ : **H 01 L 29/80, H 01 L 29/74, H 01 L 29/76**

(54) **Diode blocable, et procédé de fabrication.**

(30) Priorité : **14.04.80 FR 8008271**

(43) Date de publication de la demande :
**21.10.81 Bulletin 81/42**

(45) Mention de la délivrance du brevet :
**13.06.84 Bulletin 84/24**

(84) Etats contractants désignés :
**AT BE CH DE FR GB IT LI LU NL SE**

(56) Documents cités :
**DE-A- 2 824 133**
**DE-A- 3 002 526**
**FR-A- 2 204 047**
**FR-A- 2 227 645**
**GB-A- 2 013 030**

(73) Titulaire : **THOMSON-CSF**
**173, Boulevard Haussmann**
**F-75379 Paris Cedex 08 (FR)**

(72) Inventeur : **Arnould, Jacques**
**THOMSON-CSF SCPI 173, bld Haussmann**
**F-75360 Paris Cedex 08 (FR)**
Inventeur : **Tonnel, Eugène**
**THOMSON-CSF SCPI 173, Haussmann**
**F-75360 Paris Cedex 08 (FR)**

(74) Mandataire : **de Beaumont, Michel et al**
**THOMSON-CSF SCPI 173, Bld Haussmann**
**F-75379 Paris Cedex 08 (FR)**

Jouve, 18, rue St-Denis, 75001 Paris, France

**0 038 239**

**Description**

La présente invention concerne des diodes blocables par effet de champ et leur procédé de fabrication.

Dans divers types de composants semiconducteurs, discrets ou intégrés, tels que des transistors bipolaires de grande puissance, des thyristors ouvrables par la gâchette, des transistors à effet de champ vertical de puissance à jonction et autres, on trouve une couche profonde localisée en forme de grille disposée à l'intérieur de la plaquette semiconductrice dans un plan parallèle à celui des faces principales de cette plaquette.

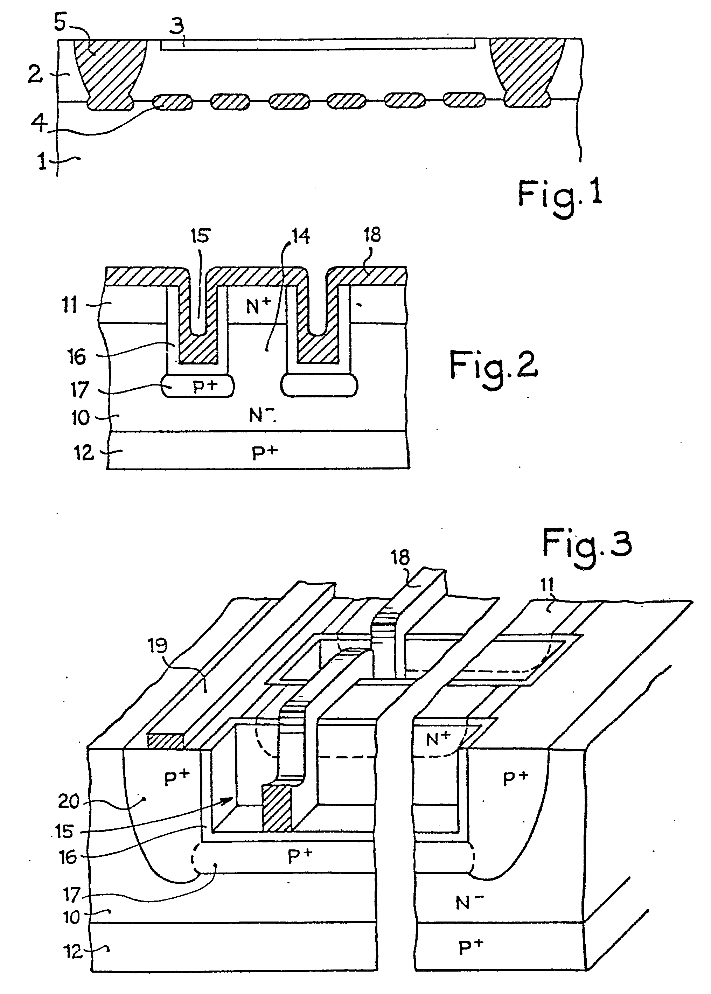

De telles couches profondes sont couramment désignées dans la technique par l'appellation grilles enterrées en raison du procédé de fabrication classique de l'art antérieur par lequel elles étaient obtenues. En effet, ce procédé consistait à partir d'un substrat semiconducteur, à y implanter des atomes dopants selon le type de conductivité correspondant à celui de la grille que l'on voulait obtenir, puis à former au-dessus de ce substrat une ou plusieurs couches épitaxiées dans lesquelles sont éventuellement formées une ou plusieurs diffusions. Une telle structure est représentée schématiquement dans la figure 1 ci-jointe. On peut y voir le substrat 1 surmonté d'une couche épitaxiée 2 dans laquelle est formée une zone diffusée 3. La couche ou grille enterrée 4 est présente à la limite entre le substrat 1 et la couche épitaxiée 2. Ensuite, un contact est assuré entre la surface supérieure de la plaquette semiconductrice et la grille enterrée 4 au moyen d'une diffusion profonde 5. Dans de nombreuses applications pratiques, la grille 4 doit avoir un pas extrêmement fin et bien déterminé. En outre, cette grille sert couramment à l'ouverture du dispositif semiconducteur. Il est alors nécessaire que la résistivité transversale de la couche de grille soit la plus faible possible. Son niveau de dopage doit donc être très important. Ce haut niveau de dopage rend difficile de maîtriser avec une grande précision l'étendue de la diffusion à partir de la couche initialement implantée pour que les mailles de la grille ne se referment pas. Le contrôle de cette diffusion est très délicat à réaliser notamment du fait que des diffusions parasites du dopant implanté peuvent se produire lors de la formation de la couche épitaxiée.

Ces inconvénients sont d'autant plus notables que, dans de nombreux dispositifs, on a cherché à réaliser de façon pratique des dimensions de mailles de grilles de l'ordre de quelques microns. D'autre part, du fait même de l'utilisation d'une couche épitaxiée déposée sur un substrat, la présence de défauts à l'interface couche épitaxiée-substrat est à l'origine d'un courant de fuite excessif de la jonction de grille qui gêne le bon fonctionnement du dispositif dans des conditions satisfaisantes.

Un exemple de diode blocable à couche enterrée sous une couche épitaxiée est décrit dans la demande de brevet allemand 2 824 133.

Ainsi, un objet de la présente invention est de prévoir une nouvelle structure de dispositifs semiconducteurs à grille profonde qui pallie les inconvénients structurels ou de fabrication des dispositifs à grille enterrée de l'art antérieur.

Un autre objet de la présente invention est de prévoir une telle structure du type diode blocable.

Un autre objet de la présente invention est de prévoir un nouveau procédé de fabrication de dispositif semiconducteur à grille profonde.

Pour atteindre ces objets ainsi que d'autres, la présente invention prévoit une structure de dispositif semiconducteur à grille profonde ne comprenant pas de couche enterrée sous une couche épitaxiée selon la technique qui a été adoptée au cours de ces dernières années.

Ainsi, la présente invention prévoit une structure de dispositif semiconducteur conforme à l'objet de la revendication 1, comprenant un corps semiconducteur comportant diverses couches de types de conductivité et/ou de niveaux de dopage distincts dont une première face comprend des rainures, dans lequel les parois latérales et le fond des rainures sont revêtus d'un agent isolant, dans lequel le fond des rainures est séparé par l'agent isolant d'une zone localisée de façon correspondante à ce fond, de type de conductivité et de niveau de dopage particuliers choisis. Les rainures peuvent optionnellement être remplies d'un matériau isolant. Dans un mode de réalisation particulier de la présente invention, le corps semiconducteur est un corps de silicium et les diverses couches isolantes mentionnées sont des couches de silice.

Bien que la présente invention puisse s'appliquer aux divers domaines mentionnés précédemment, une application particulière envisagée concerne une diode blocable, c'est-à-dire une diode ayant un comportement de thyristor dans laquelle on peut empêcher un passage initial du courant dans le sens direct par application d'une tension appropriée sur une grille profonde. Néanmoins, comme dans le cas d'un thyristor, cette diode n'est pas « ouvrable », c'est-à-dire que l'on n'escompte pas l'utiliser pour interrompre le passage d'un courant direct mais seulement pour l'empêcher de s'établir initialement quand une tension est appliquée aux bornes de la diode. Dans le cas de cette application particulière, le corps semiconducteur comprend un substrat d'un premier type de conductivité à faible niveau de dopage revêtu sur sa première face d'une première couche du même type de conductivité que le substrat et à niveau de dopage élevé et sur sa deuxième face d'une deuxième couche du type de conductivité opposé à celui du substrat et à haut niveau de dopage, les rainures mentionnées précédemment étant formées à partir de la première face, traversant la première couche s'étendant jusque dans le substrat, la couche profonde étant une couche du deuxième type de conductivité à haut niveau de dopage.

2

Un procédé de fabrication particulier d'un dispositif semiconducteur selon la présente invention et conforme à l'objet de la revendication 2, à partir d'un corps semiconducteur comprenant des couches de types de conductivité alternés, fait usage de deux produits de protection attaquables sélectivement, le deuxième produit étant un produit isolant. Ce procédé comprend les étapes consistant à : recouvrir la première face du corps semiconducteur d'une couche du premier produit de protection ; former des rainures sensiblement en U à partir de la première face ; revêtir les parois et le fond des rainures d'une couche du deuxième produit de protection ; soumettre la première face à une implantation ionique dans une direction normale à cette face, les atomes implantés ne traversant pas le premier produit de protection mais traversant le deuxième au niveau du fond des rainures ; effectuer un recuit approprié ; enlever la couche de premier produit de protection et procéder au dépôt et à la gravure des métallisations de prise de contact.

Les rainures peuvent être formées par tout procédé connu, par exemple par gravure ionique. Toutefois, dans un mode de réalisation particulier de la présente invention dans lequel le corps semiconducteur est un corps de silicium, le premier produit de protection du nitrure de silicium et le second produit de protection de l'oxyde de silicium ou silice, les rainures peuvent être formées par attaque anisotrope. Les couches de silice revêtant les parois et le fond des rainures sont formées par oxydation thermique. Un remplissage final des sillons peut être obtenu en déposant sur la première face une couche de silice dopée au phosphore et en la faisant fluer pour remplir les rainures.

Ces objets, caractéristiques et avantages ainsi que d'autres de la présente invention seront exposés plus en détail dans la description suivante de modes de réalisation particuliers faite en relation avec les figures jointes parmi lesquelles :

la figure 1, qui a été décrite précédemment était destinée à rappeler l'état de la technique ;

les figures 2 et 3 représentent des vues en coupe d'un mode de réalisation d'un dispositif à grille profonde du type diode blocable selon la présente invention, ces coupes étant prises selon des plans différents et la figure 3 étant également en perspective ;

les figures 4 à 6 illustrent des étapes de fabrication d'un dispositif selon la présente invention.

On notera que ces diverses figures ne sont en aucune manière tracées à l'échelle ni entre elles, ni à l'intérieur d'une même figure, de façon à mieux illustrer les caractéristiques de la présente invention, comme cela est usuel dans le domaine des semiconducteurs.

Les figures 2 et 3 représentent des vues en coupe partielle transversale et longitudinale d'un mode de réalisation d'un dispositif du type diode blocable selon la présente invention.

Ce dispositif comprend un corps semiconducteur comprenant un substrat 10 de type $N^-$, une couche 11 de type $N^+$ sur sa première face et une couche 12 de type $P^+$ sur sa deuxième face. Des zones en saillie 14 sont délimitées par des rainures 15. Les parois et le fond de ces rainures sont revêtus d'une couche d'un matériau isolant 16 ; le fond des rainures repose sur une zone 17 à niveau de dopage élevé et de type de conductivité P.

Comme le montre mieux la vue en perspective et en coupe longitudinale de la figure 3, on procède ensuite au dépôt d'une métallisation 18 recouvrant la plus grande partie de la première face ou cathode de la diode. Cette métallisation n'est représentée que de façon partielle par souci de clarté dans la figure 3. Elle s'étend en fait sur la plus grande partie de la face principale et pratiquement sur toute la longueur des sillons. Une partie de la métallisation pénètre dans les sillons. Elle n'a néanmoins pas de rôle néfaste à cet emplacement car les sillons sont isolés. Si, du fait du procédé de dépôt de la métallisation et de la structure particulière des sillons ou rainures 15, la métallisation se brise au niveau des rebords des sillons, cela ne constitue pas un inconvénient dans la mesure où l'on prend ensuite un contact par pression sur cette métallisation. La figure 3 représente également une métallisation de grille 19 en relation de conduction électrique avec la zone profonde de type $P^+$ 17. La conduction entre cette métallisation 19 et la zone profonde 17 est assurée par un mur ou diffusion profonde 20 de type $P^+$ formé à la limite longitudinale des sillons, et n'entrant pas en contact avec les régions $N^+$ 11.

Bien entendu, la structure représentée à la figure 3 ne l'est qu'à titre illustratif et est susceptible de nombreuses variantes. Notamment, les rainures, au lieu de constituer des bandes parallèles peuvent former un quadrillage ou avoir toute autre forme choisie. Dans le cas où ces rainures forment un quadrillage, on pourra prévoir qu'une ou plusieurs rainures sont plus larges que les autres et que la couche d'isolement de fond de ces rainures est enlevée pour y déposer directement la métallisation 19 de contact de grille en évitant la formation du mur 20. On notera d'ailleurs que ce mur, quand il existe, est de préférence formé par diffusion profonde avant la formation des sillons pour éviter une étape de diffusion longue au cours de laquelle la couche 17 qui est de préférence formée par implantation comme on le verra ci-après, serait susceptible de diffuser de façon excessive. Selon une autre variante de la présente invention, avant de procéder au dépôt de la métallisation 18, les sillons peuvent être remplis d'un matériau isolant pour éviter des phénomènes parasites tels que des ruptures de la couche de métallisation 18 évoquées précédemment.

On peut ainsi obtenir une structure à grille profonde présentant par rapport aux structures à grille enterrée de l'art antérieur de nombreux avantages structurels résultant notamment du fait que la zone diffusée 17 est nettement délimitée par la partie du sillon isolée latéralement 16.

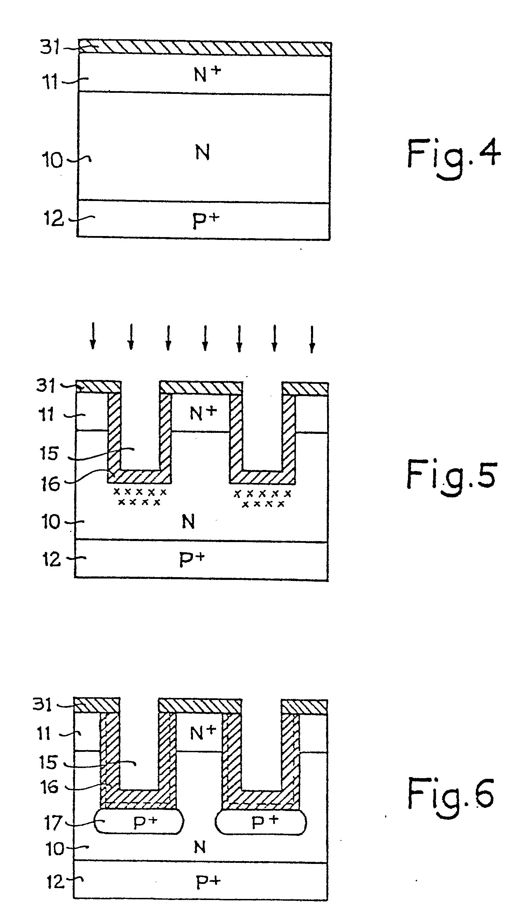

Un procédé de fabrication d'une structure telle que représentée en figures 2 et 3 va maintenant être décrit plus en détail en relation avec les figures 4 à 6.

La figure 4 représente un corps de silicium 10 et les régions 11 et 12, sur la première face ou face supérieure duquel on a formé une couche de protection 31 en nitrure de silicium ($Si_3N_4$). Des rainures en U 15 peuvent y être formées de toute façon connue, par exemple par gravure ionique. Dans le cas où l'on part d'un substrat de silicium d'orientation (1, 1, 0), on pourra former des ouvertures en des emplacements choisis de la couche de nitrure de silicium, par exemple selon un quadrillage en parallélogrammes d'angles 70 et 110° (non représenté). Ces ouvertures dans la couche de nitrure de silicium servent de masque d'attaque pour effectuer une gravure anisotrope de la plaquette et fournir les sillons en U 15 représentés dans la figure 5. Les crêtes des ouvertures sont alors alignées sur les directions (2, 1, 1) et les faces latérales sont constituées par des plans (1, 1, 1). Une étape d'échauffement thermique en atmosphère oxydante permet d'oxyder les parois et le fond des rainures de façon à former une couche d'isolement 16 en silice ($SiO_2$).

On procède ensuite à une implantation d'ions conférant un type $P^+$ au silicium, du bore par exemple, selon une incidence normale à la surface de la plaquette de façon à réaliser cette implantation dans le substrat à travers la couche de silice se trouvant au fond des rainures 15. Bien entendu, les épaisseurs relatives de la couche de nitrure 31 et de la couche de silice thermique 16 sont choisies pour éviter toute implantation à travers la couche de nitrure 31. Dans lafigure 5, les flèches verticales symbolisent la direction d'implantation normale et les croix en-dessous des fonds des sillons les zones implantées. On obtient ainsi une zone implantée d'étendue strictement délimitée en conformité avec la configuration des fonds de sillons ou rainures 15.

Dans une étape ultérieure, illustrée en figure 6, on procède à un recuit en atmosphère oxydante pour faire diffuser les ions implantés et obtenir la zone profonde diffusée 17 en-dessous des fonds des sillons. Au cours de cette étape, on pourra faire croître la couche d'oxyde 16 isolant les parois et le fond des sillons. En effet, il est possible que, par suite de l'implantation, le caractère isolant du fond des sillons soit quelque peu dégradé.

Ensuite, au cours d'étapes ultérieures, on enlève la couche de nitrure 31 par un procédé d'attaque sélective, par exemple par une attaque au plasma, et l'on procède aux diverses métallisations propres à fournir une structure, par exemple du type illustré en figures 2 et 3, constituant une diode blocable. Mais, de façon plus générale, la présente invention concerne un procédé de formation d'une grille profonde sous des sillons isolés pour une telle diode blocable.

Selon l'un des avantages de la présente invention, l'étape de formation de la couche de grille profonde 17 est l'une des dernières étapes du procédé de fabrication et n'est suivie d'aucune autre étape d'épitaxie ou de diffusion pouvant entraîner une diffusion parasite de cette zone 17. Ainsi, la profondeur ou épaisseur de la zone 17 à partir du sillon peut être contrôlée avec une grande précision. On évite ainsi les phénomènes de diffusion qui rendent si difficile technologiquement la réalisation de structures à grille enterrée à pas très fin du type de celle illustrée en figure 1.

En utilisant les techniques exposées précédemment, on pourra réaliser un dispositif pratique, par exemple à grille parallélépipédique présentant les caractéristiques dimensionnelles suivantes :

| | |
|---|---|
| — profondeur totale des sillons : | 5 à 50 microns |
| — distance entre sillons : | 10 à 15 microns |
| — largeur des sillons : | 3 à 5 microns |
| — largeur ou profondeur de la couche 17 : | 2 à 3 microns. |

La présente invention n'est pas limitée aux modes de réalisation qui ont été explicitement décrits. Elle en comprend les diverses variantes et généralisations incluses dans le domaine des revendications ci-après.

**Revendications**

1. Diode blocable comprenant un substrat (10) d'un premier type de conductivité à faible niveau de dopage revêtu sur sa première face d'une première couche (11) du même type de conductivité et à niveau de dopage élevé et sur sa deuxième face d'une deuxième couche (12) du type de conductivité opposé à haut niveau de dopage, la première face comportant des rainures (15), le fond de chaque rainure étant adjacent à une zone (17) du deuxième type de conductivité à haut niveau de dopage, caractérisée en ce que les rainures traversent la première couche et s'étendent jusque dans le substrat (10) en ce que les parois et le fond de chaque rainure sont revêtus d'un agent isolant (16).

2. Procédé de fabrication d'une diode blocable selon la revendication 1, utilisant deux produits de protection attaquables sélectivement, caractérisé en ce qu'il comprend les étapes suivantes :

a) recouvrir la première face du corps semiconducteur formé du substrat et des deux couches dopées (11 et 12) d'une couche du premier produit de protection ;

b) former « lesdites » rainures sensiblement en U à partir de la première face ;

c) revêtir les parois et le fond des rainures d'une couche du deuxième produit de protection ;

d) soumettre la première face à une implantation ionique dans une direction normale à cette face, les atomes implantés ne traversant pas le premier produit de protection mais traversant le deuxième au niveau du fond des rainures ;

e) effectuer un recuit approprié ;

f) enlever la couche du premier produit de protection et procéder au dépôt et à la gravure de métallisations de prise de contact.

3. Procédé selon la revendication 2, caractérisé en ce que le corps semiconducteur est formé à partir d'un substrat de silicium, le premier produit de protection étant du nitrure de silicium (Si₃N₄) et le second produit de protection de la silice (SiO₂).

4. Procédé selon la revendication 2, caractérisé en ce que les rainures en U sont formées par gravure ionique.

5. Procédé selon la revendication 3, dans lequel le corps semiconducteur est formé à partir d'un substrat de silicium d'orientation (1, 1, 0) caractérisé en ce que les rainures en U sont formées par attaque anisotrope après avoir ouvert la couche de nitrure selon une configuration présentant des orientations élémentaires choisies.

6. Procédé selon la revendication 3, caractérisé en ce que l'étape c) consiste en une étape d'oxydation thermique.

7. Procédé selon la revendication 6, caractérisé en ce que l'étape e) consiste en une étape d'oxydation thermique supplémentaire pour améliorer les caractéristiques isolantes des parois et du fond des rainures.

8. Procédé selon la revendication 3, caractérisé en ce qu'il comprend en outre entre les étapes e) et f) une étape supplémentaire consistant à remplir les sillons d'un produit isolant.

9. Procédé selon la revendication 8, caractérisé en ce que l'étape supplémentaire consiste à déposer sur la première face une couche de silice dopée au phosphore et à faire fluer cette silice dopée pour remplir les rainures.

**Claims**

1. Blockable diode comprising a substrate (10) of a first conductivity type having a low doping level and covered on its first face by a first layer (11) of the same conductivity type and of high doping level and on its second face by a second layer (12) of the opposite conductivity type having a high doping level, the first face comprising grooves (15), the bottom of each groove being adjacent to a zone (17) of the second conductivity type and having a high doping level, characterized in that the grooves cross the first layer and extend into the substrate (10) and in that the walls and the bottom of each groove are covered by an insulating material (16).

2. Method of producing a blockable diode according to claim 1, using two selectively attackable protection materials, characterized in that it comprises the following steps :

a) covering the first face of the semiconductor body formed of the substrate and the two doped layers (11 and 12) by a layer of the first protection material ;

b) forming said substantially U-shaped grooves from the first face ;

c) covering the wall and the bottom of the grooves with a layer of the second protection material ;

d) subjecting the first face to an ion implantation in a direction normal to said face, the implanted atoms not crossing the first protection material but crossing the second at the bottom of the grooves ;

e) performing an appropriate annealing ;

f) removing the layer of the first protection material and depositing and engraving the contacting metallization.

3. Method according to claim 2, characterized in that the semiconductor body is formed of a silicon substrate, the first protection material being silicon nitride (Si₃N₄) and the second protection material being silica (SiO₂).

4. Method according to claim 2, characterized in that the U-shaped grooves are formed by ion etching.

5. Method according to claim 3, wherein the semiconductor body is formed of a silicon substrate having the orientation (1, 1, 0) characterized in that the U-shaped grooves are formed by anisotropic attack after having opened the nitride layer according to a pattern having selected elementary orientations.

6. Method according to claim 3, characterized in that the step c) consists in a thermal oxidation step.

7. Method according to claim 6, characterized in that the step e) consists in an additional thermal oxidation step improving the insulation characteristics of the walls and of the bottom of the grooves.

8. Method according to claim 3, characterized in that it further comprises between steps e) and f) an additional step consisting in filling the grooves with an insulating material.

9. Method according to claim 8, characterized in that the additional step consists in depositing a phosphorous doped silica layer on the first face and causing said doped silica to flow in a manner to fill the grooves.

**Ansprüche**

1. Sperrbare Diode mit einem Substrat (10) eines ersten Leitungstyps und von niedrigem Dotierungsniveau, das auf seiner ersten Fläche mit einer ersten Schicht (11) desselben Leitungstyps und von hohem Dotierungsniveau und auf seiner zweiten Fläche mit einer zweiten Schicht (12) des entgegengesetzten Leitungstyps und mit hohem Dotierungsniveau bedeckt ist, wobei die erste Fläche Rillen (15) aufweist und der Boden jeder Rille an eine Zone (17) des zweiten Leitungstyps und von hohem Dotierungsniveau angrenzt, dadurch gekennzeichnet, daß die Rillen die erste Schicht durchqueren und sich bis in das Substrat (10) hinein erstrecken und daß die Wände und der Boden jeder Rille mit einem Isolierstoff (16) bedeckt sind.

2. Verfahren zur Herstellung einer sperrbaren Diode nach Anspruch 1, unter Anwendung von zwei selektiv angreifbaren Schutzstoffen, dadurch gekennzeichnet, daß es folgende Schritte enthält :

a) Bedecken der ersten Fläche des aus dem Substrat und den beiden dotierten Schichten (11 und 12) gebildeten Halbleiterkörpers mit einer Schicht aus dem ersten Schutzstoff ;

b) Bildung der genannten, im wesentlichen U-förmigen Rillen von der ersten Fläche ausgehend ;

c) Bedecken der Wände und des Bodens der Rillen mit einer Schicht aus dem zweiten Schutzstoff ;

d) Vornahme einer Ionenimplantation an der ersten Fläche und in einer zu dieser Fläche senkrechten Richtung, wobei die implantierten Atome nicht den ersten Schutzstoff, wohl aber den zweiten am Boden der Rillen durchqueren ;

e) Vornahme einer geeigneten Wärmebehandlung ;

f) Entfernen der ersten Schutzstoffschicht und Vornahme der Ablagerung und Gravierung von Kontaktierungsmetallisierungen.

3. Verfahren nach Anspruch 2, dadurch gekennzeichnet, daß der Halbleiterkörper aus einem Siliziumsubstrat gebildet ist, der erste Schutzstoff Siliziumnitrid ($Si_3N_4$) und der zweite Schutzstoff Siliziumoxid ($SiO_2$) ist.

4. Verfahren nach Anspruch 2, dadurch gekennzeichnet, daß die U-förmigen Rillen durch Ionengravierung gebildet sind.

5. Verfahren nach Anspruch 3, bei welchem der Halbleiterkörper aus einem Siliziumsubstrat der Orientierung (1, 1, 0) gebildet ist, dadurch gekennzeichnet, daß die U-förmigen Rillen durch anisotropen Angriff gebildet, sind, nachdem die Nitridschicht gemäß einer Gestalt geöffnet wurde, welche die gewählten elementaren Orientierungen aufweist.

6. Verfahren nach Anspruch 3, dadurch gekennzeichnet, daß der Schritt c) in einem thermischen Oxidationsschritt besteht.

7. Verfahren nach Anspruch 6, dadurch gekennzeichnet, daß der Schritt e) in einem zusätzlichen thermischen Oxidationsschritt besteht, um die Isoliereigenschaften der Wände und des Bodens der Rillen zu verbessern.

8. Verfahren nach Anspruch 3, dadurch gekennzeichnet, daß es ferner zwischen den Schritten e) und f) einen zusätzlichen Schritt enthält, der darin besteht, die Rillen mit einem Isolierstoff auszufüllen.

9. Verfahren nach Anspruch 8, dadurch gekennzeichnet, daß der zusätzliche Schritt darin besteht, auf der ersten Fläche eine mit Phosphor dotierte Siliziumoxidschicht abzulagern und dieses dotierte Siliziumoxid fließfähig zu machen, um die Rillen auszufüllen.

Fig.1

Fig.2

Fig.3

0 038 239

Fig.4

Fig.5

Fig.6

2